# EUROPÄISCHE PATENTSCHRIFT

(11) **EP 1 190 433 B1**
(45) Veröffentlichungstag und Bekanntmachung des Hinweises auf die Patenterteilung: **24.08.2011**
(21) Anmeldenummer: 00947795.1
(22) Anmeldetag: 14.06.2000
(51) Int. Cl.: H01J 37/153

(54) **ELEKTROSTATISCHER KORREKTOR ZUR BESEITIGUNG DES FARBFEHLERS VON TEILCHENLINSEN**
ELECTROSTATIC CORRECTOR FOR ELIMINATING THE CHROMATIC ABERRATION OF PARTICLE LENSES
CORRECTEUR ELECTROSTATIQUE PERMETTANT DE SUPPRIMER LES ABERRATIONS CHROMATIQUES DE LENTILLES A PARTICULES

(30) Priorität: 14.06.1999 DE 19926927
(43) Veröffentlichungstag der Anmeldung: 27.03.2002
(73) Patentinhaber: Ceos Corrected Electron Optical Systems GmbH, 69126 Heidelberg (DE)
(72) Erfinder: ROSE, Harald, D-64287 Darmstadt (DE); UHLEMANN, Stephan, D-69126 Heidelberg (DE); WEISSBÄCKER, Christoph, D-64807 Dieburg (DE)
(74) Vertreter: Pöhner, Wilfried Anton
(86) Internationale Anmeldenummer: PCT/DE2000/001882
(87) Internationale Veröffentlichungsnummer: WO 2000/077819

(56) Entgegenhaltungen:
- WO-A-99/27558
- DE-A- 4 204 512
- US-A- 4 555 666
- SCHERZER: "Sphärische und chromatische Korrektur von Elektronen-Linsen" OPTIK,DE,JENA, 1947, Seiten 114-132, XP002090897 ISSN: 0863-0259
- KRIVANEK O L ET AL: "Towards sub-AA electron beams", ULTRAMICROSCOPY, ELSEVIER, AMSTERDAM, NL, vol. 78, no. 1-4, 6 September 1998 (1998-09-06), pages 1-11, XP002268145, ISSN: 0304-3991

## Beschreibung

Die Erfindung betrifft einen elektrostatischen Korrektor zur Beseitigung des Farbfehlers von Teilchenlinsen mit gerader optischer Achse gemäß Oberbegriff des Anspruches 1.

Durch das Scherzer-Theorem (o. Scherzer, Zeitschrift für Physik 101, (1936) 593) ist bekannt, daß in optisch abbildenden Systemen für geladene Teilchen, unter denen vor allen Elektronen und Ionen zu verstehen sind, bei Verwendung statischer, raumladungsfreier und rotationssymmetrischer Feldern die chromatische Aberration (Farbfehler) und die sphärische Aberration (Öffnungsfehler) grundsätzlich nicht verschwinden. Da diese Fehler die Leistungsfähigkeit der abbildenden optischen Systeme und im speziellen das Auflösungsvermögen begrenzen, hat es nicht an Versuchen gefehlt, diese Bildfehler zu beseitigen. Am meisten Erfolg verspricht das Abgehen von rotationssymmetrischen Feldern, also die Verwendung unrunder Linsen in Form von Multipolen, also insbesondere Quadrupolen, Oktopole udgl. Mit Hilfe eines derartigen aus elektrischen und magnetischen Multipolen aufgebauten Korrektor gelang es den beiden Geschäftsführern der Anmelderin die sphärische und chromatische Aberration in einem Niederspannungsrasterelektronenmikroskop vollständig zu korrigieren (J. Zach, M. Haider Nucl. Instr. method. A363 (1995) 316), wobei ein Auflösungsvermögen von 2 nm bei einer Elektronenenergie von 1kv nachgewiesen werden konnte. Aus der WO 99/27558 ist ein chromatischer Korrektor bestehend aus 10 und mehr elektrostatischen Dipollinsen bekannt. Im Stande der Technik wird eine Anordnung offenbart, die aus zwei Korrekturstücken besteht, die ihrerseits aus Quadrupolen und Zylinderlinsen zusammengesetzt sind, wobei die Korrekturstücke im Bereich der jeweiligen astigmatischen Zwischenbilder angeordnet sind.

Die Nachteile der elektromagnetischen Multipolkorrektoren sind darin zu sehen, daß die Magnetfelder aufgrund der Remanenz keine schnelle und präzise sowie reproduzierbare Justierung der magnetischen Felder erlauben. Eine Entmagnetisierung erfordert zudem einen erheblichen Aufwand darstellenden Ausbau der Spulenkerne. Über einen längeren Zeitraum stellt sich eine relativ große Drift der Magnetfelder ein. Schließlich lassen sich die in Ionenoptischen Geräten, wie z. B. der Lithographie, aufgrund der großen Ionenmassen notwendigen starken magnetischen Feldstärken wegen der Abhängigkeit der Fokusierung von der Masse nur schwer realisieren. Korrektoren zur Beseitigung des Farbfehlers mit in beiden Schnitten rein elektrischen Feldern sind unbekannt.

Hiervon ausgehend hat sich die Erfindung die Schaffung eines Korrektors zur Beseitigung des Farbfehlers von Teilchenlinsen zur Aufgabe gemacht, der ausschließlich aus elektrischen Feldern, also unter Verzicht auf magnetische Felder, aufgebaut ist. Gelöst wird diese Aufgabe erfindungsgemäß dadurch, dass jedes Korrekturstück aus drei elektrischen Quadrupolfeldern mit überlagerten Rundlinsenfeldern besteht.

Der Begriff Farbfehler meint im Sinne der Erfindung unter Anwendung der exakten Terminologie den axialen Farbfehler erster Ordnung ersten Grades. Hierbei beschreibt das Wort "axial", dass dieser Farbfehler nur bestimmt wird, durch die Gegenstandspunkt von der optischen Achse ausgehenden Fundamentalbahnen, d. h. den Fundamentallösungen der Gaußschen Optik. Der Farbfehler ist also unabhängig von außeraxialen Bahnen. Die Ordnung beschreibt die Potenz, mit welcher die Anfangssteigung der Fundamentalbahn in die Fehlerabweichung eingeht; im Falle erster Ordnung besteht eine lineare Abhängigkeit. Der Begriff "ersten Grades" beschreibt, dass die Fehlerabweichung linear von der relativen Geschwindigkeitsabweichung der mittleren Geschwindigkeit der Teilchen abhängt. Im Falle monochromatischer Teilchen - d. h. Teilchen gleicher Geschwindigkeit und damit auch konstanter Wellenlänge - werden die relativen Abweichungen damit zu Null. In diesem Fall entsteht kein Farbfehler. In der Sprache der Optik wird der Farbfehler häufig auch als chromatische Aberration bezeichnet.

Der vorgeschlagene elektrostatische Korrektor besteht in seinen grundsätzlichen Aufbau aus vier in Richtung der geraden optischen Achse hintereinander angeordneten Elementen, nämlich - in Richtung des Strahlenganges ausgehend von dem Objektiv - zunächst aus einem Quadrupol und zwei sich hintereinander hieran anordnende Korrekturstücke und schließlich - ausgangsseitig - aus einem weiteren Quadrupol. Die Quadrupolfelder der beiden Korrekturstücke sind gegeneinander um einen Winkel von 90° um die optische Achse gedreht.

Der Strahlengang im Korrektur verläuft wie folgt: Der von der Mitte des Objektes ausgehende axiale Strahlengang wird als erstes durch die Objektivlinse umgelenkt und nach dem Eintritt in den Korrektor zunächst durch den elektrischen Quadrupol in beiden Schnitten (X-, Y-Schnitt) unterschiedlich abgelenkt. Das Teilchenbündel wird dadurch in einem Schnitt fokussiert (z. B. im X-Schnitt) und im anderen auseinandergezogen (Y-Schnitt), so daß ein astigmatisches Zwischenbild entsteht, das die optische Achse durchsetzt und zweckmäßigerweise in die Mitte des ersten Korrekturstücks gelegt wird. Dieses Korrekturstück beeinflußt deshalb nicht wesentlich den Bahnverlauf in dem Schnitt in dem das Zwischenbild liegt (X-Schnitt), weil die axiale Bahn nahe der optischen Achse verläuft und diese schneidet, wobei zwar positive Farbfehler entstehen, die aber aufgrund des geringen Achsenabstandes nur sehr klein ausfallen. Im dazu senkrechten Schnitt (Y-Schnitt) hingegen erfährt der Bahnverlauf durch die Quadrupolfelder des Korrektorstückes eine erhebliche Beeinflussung und einen negativen Beitrag zum Farbfehler. Somit erfolgt eine Beeinflussung des Farbfehlers des einen Schnittes im ersten Korrekturstück und der des zweiten Schnittes im zweiten Korrekturstück in analoger Weise. In Abhängigkeit von den eingestellten Potentialen wird eine Beeinflussung des Farbfehlers und im idealen Fall eine Kompensation des Farbfehlers der Objektivlinse erfolgen, sodaß das gesamte aus Objektivlinse und Korrektor gebildete optische System von Farbfehlern freie Abbildungseigenschaften aufweist. Der letzte Quadrupol dient dazu den Strahlengang wieder zur Rotationssymmetrie zusammenzusetzen.

Die Erzeugung des astigmatischen Zwischenbildes innerhalb des Korrekturstückes, d.h. der Nulldurchgang der entsprechenden paraxialen Bahn läßt sich durch entsprechende Wahl der Stärke des am Eingang des Korrektors befindlichen elektrischen Quadrupols erreichen. Durch Veränderung des Potentials der elektrischen Quadrupolfelder des Korrekturstückes (Rundlinsenanteil als auch Quadrupolfeldstärke) zueinander, also des Gegenfeldes zwischen den Quadrupolfeldern, erfolgt die Beeinflussung und Einstellung des Farbfehlers.

Die entscheidenden Vorteile des elektrostatischen Korrektors bestehen in einer schnellen und präzisen Justierung und Einstellung der Felder, eine problemlose Handhabung mit reproduzierbaren Verhältnissen auch über einen längeren Zeitraum und auch in der möglichen Verwendung in ionenoptischen Geräten.

Als besonders bevorzugt gelten Ausgestaltungen, bei denen ein symmetrischer Aufbau und/oder symmetrischer Verlauf innerhalb eines Korrekturstückes zu deren Mittelebene und/oder ein symmetrischer Aufbau und/oder symmetrischer Verlauf der Felder der beiden Korrekturstücke, zu der dazwischen befindlichen Mittelebene vorgesehen ist. Aufgrund des symmetrischen/antisymmetrischen Verlaufes der paraxialen Bahnen innerhalb der Korrekturstücke heben sich zahlreiche Fehlerintegrale auf oder werden doch zumindest auf analytische Weise übersichtlich und problemlos lösbar, was wesentlich zur Transparenz und zum Verständnis des Verhaltens des Korrektors in unterschiedlichen Situationen und Einstellungen beiträgt. Die Symmetrie zur Mittelebene eines Korrekturstückes sowohl im Aufbau als auch in der Einstellung der elektrischen Felder hat zur Folge, daß der Nulldurchgang der entsprechenden Paraxialbahn exakt in die Mittelebene zu liegen kommt. Zudem sind die beiden äußeren Quadrupolfelder des selben Korrekturstückes dann identisch.

Aufgrund Aufbau und Symmetrie der Felder der beiden Korrekturstücke unter Beibehaltung der relativen Verdrehung gegeneinander um 90 Grad erhält man in beiden Schnitten einen gleichen Bahnverlauf, d.h. die im ersten Korrekturstück vorgenommene Korrektur des einen Schnittes erfolgt im anderen Schnitt im zweiten Korrekturstück.

Einfache analytische Lösbarkeit und aufgrund der Übersichtlichkeit in einem daraus resultierenden Verständnis des Verhaltens des Korrektors sind die hieraus resultierenden Vorzüge. Es vereinfachen sich nicht nur die Justierung sondern die Handhabung generell; die Möglichkeit der Einstellung weniger Potentiale trägt ebenfalls zur Erleichterung bei.

Zur Einstellung des Korrektors:
Grundsätzlich besteht die Möglichkeit durch Beeinflussung des Farbfehlers eine in weiten Grenzen beliebige Einstellung des Farbfehlers des aus Objektivlinse und Korrektor bestehenden Gesamtsyste zu erreichen. Häufig besteht das erklärte Ziel darin, den Gesamtfehler des optischen Systemes zu Null zu machen, d.h. durch den Korrektor einen negativen Farbfehleranteil zu erzeugen, der den sich aus Objektivlinse und den einzelnen Korrekturelementen erzeugten weiteren positiven Farbfehler zu Null kompensiert. Bei den vorbeschriebenen symmetrischen Verhältnissen stehen zur Einstellung des Korrekturstücks nur zwei Parameter zur Verfügung, nämlich das Verhältnis des äußeren und mittleren Rundlinsenfeldes sowie die Stärke des Quadrupolfeldes.

Die Beseitigung des Farbfehlers geschieht in einem iterativen Prozeß, der im Falle des vorbeschriebenen symmetrischen Aufbaus ebenfalls besonders übersichtlich wird und im folgenden kurz geschildert werden soll:
Bei konstantem Verhältnis der beiden Rundlinsenpotentiale des Korrekturstückes wir die Quadrupolstärke verändert und hierbei der Farbfehlerkoffizient gemessen. Sobald der Farbfehler seinen Minimalwert annimmt, wird das Verhältnis des Rundlinsenfeldes ebenfalls verändert mit dem Ziel der weiteren Minimierung des Farbfehlers. Durch mehrere iterative Schritte in der vorbeschriebenen Weise läßt sich der Farbfehler dann vollständig beseitigen. Mathematische Überlegungen zeigen, daß eine vollständige Korrektur des Farbfehlers nur für bestimmte Bereiche der Rundlinsenpotentiale des Korrekturstückes sowie der Quadrupulfeldstärken möglich sein wird.

Wie eingangs erwähnt, wird die Leistungsfähigkeit elektronenoptischer Abbildungssystem durch Farbfehler (chromatische Aberration) und Öffnungsfehler (sphärische Aberration) begrenzt. Die Aufgabe des bisher beschriebenen Korrektors besteht in der Beseitigung des axialen Farbfehlers erster Ordnung ersten Grades. In zahlreichen Anwendungsfällen ist man bestrebt, zusätzlich die sphärische Aberration genauer den axialen Öffnungsfehler dritter Ordnung zu beseitigen. Hierzu werden Oktopolfelder, also vierzählige Felder den Quadrupolfeldern überlagert. Bei dem als besondere Ausgestaltung beschriebenen symmetrischen Aufbau überlagert das Oktopolfeld das mittlere Quadrupolfeld des Korrekturstückes. Durch die Wahl und Einstellung der Stärke des Oktopolfeldes erfolgt eine Einstellung und ggf. Kompensation des axialen Öffnungsfehlers dritter Ordnung völlig entkoppelt von der Einstellung der der Beseitigung des Farbfehlers dienenden Quadrupolfelder.

Für die bauliche Realisierung ist es möglich, in einem einzigen Multipolelement, Quadrupol als auch Oktopolfelder zu erzeugen.

In einer bevorzugten Weiterbildung wird die Anordnung eines weiteren, dritten Korrekturstückes in Richtung der optischen Achse hinter dem bisherigen aus zwei Korrekturstücken bestehenden Korrektor vorgeschlagen. Sowohl im Hinblick auf die räumliche Anordnung als auch auf die Stärke der Quadrupol- und Rundlinsenfelder wird eine zur Mittelebene des zweiten Korrekturstückes und damit zu der durch die Mitte des aus drei Korrekturstücken bestehenden Korrektors verlaufenden Ebene spiegelsymmetrische Anordnung vorgeschlagen. Im Ergebnis erhält man ein drittes Korrekturstück, das von spiegelsymmetrischen Aufbau zum ersten Korrekturstück ist. Für die beiden axialen, d. h. von der optischen Achse im Gegenstandspunkt ausgehenden Elementarbahnen hat die im Alpha-Schnitt verlaufende Bahn eine Punktsymmetrie bezüglich der Mitte des Korrektors und die durch die senkrecht dazu verlaufende β-Bahn eine Spiegelsymmetrie bezüglich der Mitte des Korrektors. Die außerhalb der optischen Achse ausgehenden außeraxialen Bahnen sind im Hinblick auf den Gamma-Schnitt spiegelsymmetrisch zur Mitte des Korrektors und die in der hierzu senkrechten Ebene verlaufenden Delta-Bahn verläuft punktsymmetrisch bezüglich der Mitte des Korrektors. Im ersten und dritten Korrekturstück und zwar im astigmatischen Zwischenbild der β-Bahn erfolgt eine Korrektur des Farbfehlers im xz-Schnitt. Im mittleren (zweiten) Korrekturstück folgt im astigmatischen Zwischenbild der Alpha-Bahn die Korrektur in yz-Schnitt. Im allgemeinen sind die Farbfehler in den beiden Schnitten unterschiedlich. Die optimalte Einstellung des Korrektors erhält man dann, wenn die Erregung der Korrekturstücke sowie die Geometrie insbesondere der Abstand zwischen Front-Quadrupol und ersten Korrekturstück sowie zwischen den Korrekturstücken so gewählt wird, daß eine optimale Einstellung des Korrektors vorliegt. Durch diese Änderung der Geometrie läßt sich die Einstrahlung in das zweite Korrekturstück optimieren. Obwohl die Bahneinstrahlung im ersten und dritten Korrekturstück hinsichtlich der Farbfehlerkorrektur im xz-Schnitt dann ungünstiger wird, läßt sich dieser Nachteil dadurch beseitigen, daß die Korrektur in diesem Schnitt auf zwei Korrekturstücke verteilt und damit eine Kompensation möglich wird. Aufgrund der Symmetrie der Bahnen und der Felder bezüglich der Mitte des Korrektors und damit der Mitte des zweiten Korrekturstücks lassen sich sämtiche außeraxiale Fehler mit linearen Achsenabstand eliminieren. Man erhält man die Möglichkeit der Übertragung eines ausgedehnten Bildfeldes, mit der Folge, daß dieser Korrektor sich auch zum Einsatz über die Rasterelektronenmikroskopie hinaus eignet. Hierzu trägt auch die Beseitigung des Bildfehlers der Koma bei. Als weiterer Vorzug dieser Anordnung ist die Reduzierung des Kombinationsfehler und hierbei insbesondere die Verminderung der axialen Bildfehler dritter und fünfter Ordnung anzusehen.

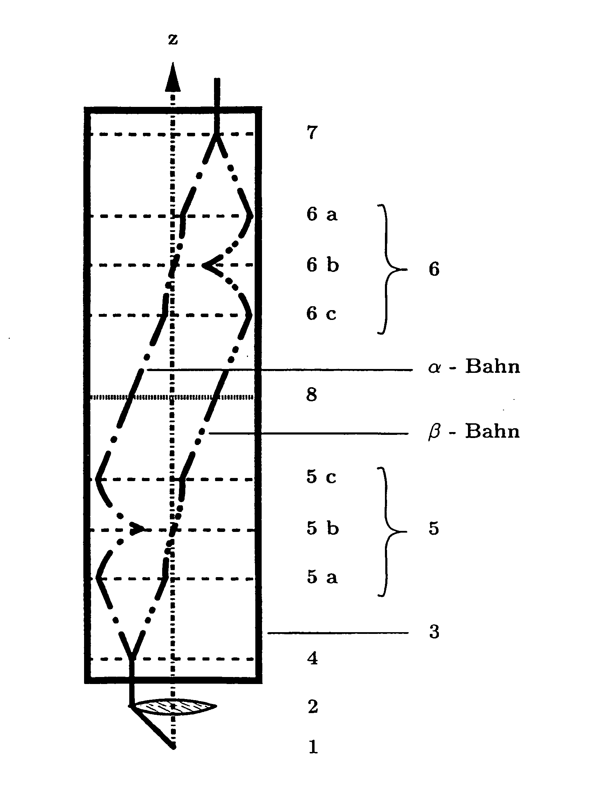

Weitere Einzelheiten, Merkmale und Vorteile der Erfindung lassen sich dem nachfolgenden Beschreibungsteil entnehmen, in dem anhand der Zeichnung Aufbau und Funktion des erfindungsgemäß vorgeschlagenen elektrostatischen Korrektors entnehmbar sind. Die paraxialen Bahnen α, β gehen vom Objekt (1) aus und werden durch die mit einem Farbfehler behaftete Objektivlinse (2) abgelenkt. Der Korrektor (3) besteht in seinem grundsätzlichen Aufbau aus einen der Objektivlinse (4) zugewandten Quadrupol einem sich in Ausbreitungsrichtung des Strahlenganges anschließenden ersten Korrekturstück (5) sowie einem im Abstand hierzu angeordneten weiteren Korrekturstück (6). Wie aus der Zeichnung erkennbar, bewirkt der Quadrupol (4) eine Aufspaltung in der in unterschiedlichen Schnitten verlaufenden axialen Bahnen a, β in unterschiedliche Richtungen, nämlich zum einen in Richtung auf optische Achse (Z) und im anderen Schnitt senkrecht hierzu. Das Korrekturstück (5) besteht aus drei Quadrupolfeldern (5a, 5b, 5c) die symmetrisch sind, d.h. die beiden äußeren Quadrupolfelder (5a, 5c) sind in ihrer Stärke gleich und liegen symmetrisch zum mittleren Quadrupolfeld (5b). Zur Herstellung eines symmetrischen Strahlenganges ist ausgangsseitig ein weiterer Quadrupol (7) angeordnet.

Der im Hinblick auf die Mittelebene (Z_{M}) symmetrische Aufbau der Korrekturstücke (5, 6) die lediglich relativ gegeneinander um die optische Achse (z) um 90 Grad gedreht sind, ergibt gleichen Bahnverlauf in der um 90 Grad gedrehten Schnittebene. Das eine Korrekturstück (5) bewirkt die Beeinflussung und Beseitigung des Farbfehlers in derjenigen Schnittebene, in der die α-Bahn verläuft. Das andere Korrekturstück (6) wirkt auf die im anderen Schnitt verlaufende β-Bahn ein, sodaß jedes der Korrekturstücke (5, 6) in einem der beiden Schnitte die Beeinflussung oder gar die Beseitigung des Farbfehlers vornehmen. Sämtliche Quadrupol- und Rundlinsenfelder sind elektrostatischer Natur.

Nicht eingezeichnet ist, daß durch Überlagerung von Oktopolfeldern vornehmlich im Bereich der astigmatischen Zwischenbilder eine Korrektur der sphärischen Aberration (axialer Öffnungsfehler 3. Ordnung) vorgenommen werden kann. Eine wesentliche Steigerung der Leistungsfähigkeit der Teilchen optischer Abbildungssysteme läßt sich durch die Beseitigung des Farbfehlers und ggf. noch des öffnungsfehlers erreichen.

## Patentansprüche

1. Elektrostatischer Korrektor zur Beseitigung des Farbfehlers von Teilchenlinsen mit gerader optischer Achse und einem einer Objektivlinse zuzuordnenden elektrostatischen Quadrupol,
wobei in Strahlrichtung hinter dem Quadrupol entlang der optischen Achse zwei Korrekturstücke angeordnet sind,
jedes Korrekturstück Quadrupole aufweist,
deren Quadrupole jedoch relativ zueinander um einen Winkel von 90 Grad um die optische Achse gedreht sind und die Einstellung derart erfolgt ist, dass das astigmatische Zwischenbild des einen Schnittes in einem Korrekturstück und das dazu senkrechte astigmatische Zwischenbild des anderen Schnittes im anderen Korrekturstück zu liegen kommt und ausgangsseitig schließlich ein weiterer elektrostatischer Quadrupol angeordnet ist,
**dadurch gekennzeichnet, dass**
- jedes Korrekturstück aus drei elektrischen Quadrupolfeldern mit überlagerten Rundlinsenfeldern besteht.

2. Korrektor nach Anspruch 1, **gekennzeichnet durch** einen symmetrischen Aufbau des Korrekturstücks und/oder einen symmetrischen Verlauf der Quadrupolfelder und Rundlinsenfelder eines Korrekturstückes zu deren Mittelebenen.

3. Korrektor nach Anspruch 1 oder 2, **gekennzeichnet durch** einen symmetrischen Aufbau des Korrektors und/oder einen symmetrischen
Verlauf der Quadrupol- und Rundlinsenfelder zu der **durch** die beiden Korrekturstücke definierten Mittelebene.

4. Korrektor nach Ansprüche 1 bis 3, **dadurch gekennzeichnet, dass** den Quadrupolen der Korrekturstücke mindestens ein Oktopolfeld überlagert ist.

5. Korrektor nach Anspruch 4, **dadurch gekennzeichnet, dass** die Oktopolfelder im Bereich der jeweiligen astigmatischen Zwischenbilder angeordnet sind.

6. Korrektor nach einem der vorhergehenden Ansprüche, **dadurch gekennzeichnet, dass** in Richtung der optischen Achse ein weiteres (drittes) Korrekturstück nachgeordnet ist, deren Rundlinsen und Quadrupolfelder in räumlicher Anordnung und Stärke spiegelsymmetrisch zur Mitte des zweiten Korrekturstückes gewählt sind.

## Claims

1. Electrostatic corrector for eliminating the chromatic aberration of particle lenses comprising a straight optical axis and an electrostatic quadrupole that can be assigned to the objective lens, two corrector pieces being positioned behind the quadrupole, along the optical axis in the direction of radiation, each corrector piece having quadrupoles,
the quadrupoles however being rotated relative to one another by an angle of 90 degrees about the optical axis, and the setting being such that the astigmatic intermediate image of one section comes to lie in one corrector piece and
the astigmatic intermediate image, perpendicular thereto, of the other section comes to lie in the other corrector piece, with, finally, another electrostatic quadrupole being located at the output side, **characterised in that**
- each corrector piece consists of three electric quadrupole fields with superimposed circular lens fields.

2. Corrector according to claim 1, **characterized by** a symmetrical construction of the corrector piece and/or a symmetrical profile of the quadrupole fields and circular lens fields of a corrector piece with respect to their centre planes.

3. Corrector according to claim 1 or 2, **characterized by** a symmetrical construction of the corrector piece and/or a symmetrical profile of the quadrupole fields and circular lens fields with respect to the centre plane defined by the two corrector pieces.

4. Corrector according to claims 1 to 3, **characterised in that** at least one octupole field is superimposed on the quadrupoles of the corrector pieces.

5. Corrector according to claim 4, **characterised in that** the octupole fields are located in the region of the respective astigmatic intermediate images.

6. Corrector according to one of the preceding claims, **characterised in that** a further (third) corrector piece is arranged downstream in the direction of the optical axis, the circular lenses and quadrupole fields thereof being chosen such that they are mirror symmetrical to the centre of the second corrector piece.

## Revendications

1. Correcteur électrostatique destiné à éliminer l'aberration chromatique de lentilles pour faisceaux de particules ayant un axe optique droit et un quadripôle électrostatique devant être attribué à une lentille d'objectif, sachant deux zones de correction sont disposées le long de l'axe optique,
chaque pièce de correction présentant des quadripôles,
dont les quadripôles sont cependant tournés l'un par rapport à l'autre d'un angle de 90 degrés autour de l'axe optique, leur réglage étant en outre effectué de manière à ce que l'image astigmatique intermédiaire d'une des coupes vienne reposer dans une zone de correction et à ce que l'image astigmatique intermédiaire à la verticale de l'autre vienne reposer dans l'autre zone de correction,
un quadripôle supplémentaire étant finalement disposé du côté de la sortie,
**caractérisé par** le fait
■ que chaque zone de correction consiste en trois champs de quadripôles ayant des champs superposés de lentilles sphériques.

2. Correcteur électrostatique conforme à la revendication 1 **caractérisé par** une construction symétrique de la zone de correction et/ou un tracé symétrique des champs de quadripôles et des champs de lentilles symétriques d'une zone de correction par rapport à leurs plans médians.

3. Correcteur électrostatique conforme à la revendication 1 ou 2 **caractérisé par** une construction symétrique du correcteur et/ou un tracé symétrique des champs de quadripôles et des champs de lentilles sphériques par rapport au plan médian défini par les deux zones de correction.

4. Correcteur électrostatique conforme à la revendication 1 à 3 **caractérisé par le fait qu'**au moins un champ d'octopôles est superposé aux quadripôles des zones de correction.

5. Correcteur électrostatique conforme à la revendication 4, **caractérisé par le fait que** les champs d'octopôles sont disposés dans la zone des images astigmatiques intermédiaires respectives.

6. Correcteur électrostatique conforme à une des revendications précédentes, **caractérisé par le fait qu'**une autre (troisième) zone de correction est disposée en arrière dans le sens de l'axe optique, dont les lentilles sphériques et les champs de quadripôles sont choisis, en termes de disposition spatiale et de puissance, dans une symétrie réfléchie par rapport au milieu de la deuxième zone de correction.
